(19) **Europäisches Patentamt European Patent Office Office européen des brevets**

(11) **EP 4 692 427 A1**

(12) **EUROPEAN PATENT APPLICATION**
published in accordance with Art. 153(4) EPC

(43) Date of publication:
**11.02.2026 Bulletin 2026/07**

(21) Application number: **24784913.6**

(22) Date of filing: **02.04.2024**

(51) International Patent Classification (IPC):
*C30B 29/04* (2006.01)  *C01B 32/28* (2017.01)
*C30B 19/02* (2006.01)  *C30B 33/04* (2006.01)
*G02B 1/02* (2006.01)  *G02B 5/22* (2006.01)

(52) Cooperative Patent Classification (CPC):
**C01B 32/28; C30B 19/02; C30B 29/04;
C30B 33/04; G02B 1/02; G02B 5/22**

(86) International application number:
**PCT/JP2024/013623**

(87) International publication number:
**WO 2024/210129 (10.10.2024 Gazette 2024/41)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **03.04.2023 JP 2023060358**

(71) Applicant: **SUMITOMO ELECTRIC INDUSTRIES,
LTD.**
**Osaka-shi, Osaka 541-0041 (JP)**

(72) Inventors:
• **SUMIYA, Hitoshi**
**Osaka-shi, Osaka 541-0041 (JP)**
• **ZUO, Yikang**
**Osaka-shi, Osaka 541-0041 (JP)**
• **TERAMOTO, Minori**
**Osaka-shi, Osaka 541-0041 (JP)**

(74) Representative: **Boult Wade Tennant LLP**
**Salisbury Square House**
**8 Salisbury Square**
**London EC4Y 8AP (GB)**

(54) **SYNTHETIC SINGLE CRYSTAL DIAMOND, METHOD FOR PRODUCING SYNTHETIC SINGLE CRYSTAL DIAMOND, AND INFRARED OPTICAL COMPONENT**

(57)    A synthetic single crystal diamond in which a content ratio of nitrogen based on the number of atoms is 1 ppm or less and a content ratio of boron based on the number of atoms is 0.01 ppm or more and 3 ppm or less, wherein the content ratio of the boron based on the number of atoms is more than the content ratio of the nitrogen based on the number of atoms, and no absorption peak exists in a wavenumber range of 2790 cm$^{-1}$ or more and 2810 cm$^{-1}$ or less in an infrared absorption spectrum of the synthetic single crystal diamond measured by Fourier transform infrared spectroscopy.

FIG.3

## Description

TECHNICAL FIELD

The present disclosure relates to a synthetic single crystal diamond, a method of producing the synthetic single crystal diamond, and an infrared optical component. The present application claims priority based on Japanese Patent Application No. 2023-060358 filed on April 3, 2023. The entire contents of the Japanese Patent Application are incorporated herein by reference.

BACKGROUND ART

As a material of an optical component used for infrared spectroscopy, there has been reviewed a synthetic diamond having such excellent properties that a transmission region is wide and the synthetic diamond is less susceptible to scratching.

In PTL 1 (Japanese Patent Laying-Open No. 6-214102), there has been reviewed an infrared optical component consisting of a total reflection prism using a synthetic diamond having a nitrogen content of 3 ppm or less and a boron content of 3 ppm or less.

CITATION LIST

PATENT LITERATURE

PTL 1: Japanese Patent Laying-Open No. 6-214102

SUMMARY OF INVENTION

A synthetic single crystal diamond according to the present disclosure is a synthetic single crystal diamond in which a content ratio of nitrogen based on the number of atoms is 1 ppm or less and a content ratio of boron based on the number of atoms is 0.01 ppm or more and 3 ppm or less, wherein

the content ratio of the boron based on the number of atoms is more than the content ratio of the nitrogen based on the number of atoms, and

no absorption peak exists in a wavenumber range of 2790 $cm^{-1}$ or more and 2810 $cm^{-1}$ or less in an infrared absorption spectrum of the synthetic single crystal diamond measured by Fourier transform infrared spectroscopy.

BRIEF DESCRIPTION OF DRAWINGS

[Fig. 1] Fig. 1 is a schematic cross sectional view showing an exemplary sample chamber configuration used to produce a synthetic single crystal diamond according to one embodiment of the present disclosure.

[Fig. 2] Fig. 2 is a diagram showing an infrared absorption spectrum of a diamond single crystal produced in a sample 7 before application of electron beam.

[Fig. 3] Fig. 3 is a diagram showing an infrared absorption spectrum of a synthetic single crystal diamond produced in sample 7 after the application of electron beam.

DETAILED DESCRIPTION

[Problem to be Solved by the Present Disclosure]

Boron in a synthetic diamond is such that boron, which is an inevitable impurity included in a carbon source (diamond powder or graphite powder) used at the time of synthesis, is incorporated into a crystal during the synthesis. The carbon source, which is industrially and stably available, includes several ten ppm to several hundred ppm of boron as an impurity, and the boron is incorporated into the synthetic diamond.

When the content ratio of the boron based on the number of atoms in the synthetic diamond is slightly more than the content ratio of nitrogen based on the number of atoms, absorption appears in a wavenumber range of 2790 $cm^{-1}$ or more and 2810 $cm^{-1}$ or less in the infrared absorption spectrum of the synthetic diamond, thus resulting in background noise. Therefore, the synthetic single crystal diamond cannot be used as an optical component for evaluating optical properties in an infrared optical analysis device. Therefore, there has been required a synthetic diamond that can be used as an infrared optical component even when the content ratio of boron based on the number of atoms is more than the content ratio of nitrogen based on the number of atoms.

Thus, it is an object of the present disclosure to provide a synthetic single crystal diamond that can be used as an infrared optical component.

[Advantageous Effect of the Present Disclosure]

According to the present disclosure, it is possible to provide a synthetic single crystal diamond that can be used as an infrared optical component.

[Description of Embodiments]

First, embodiments of the present disclosure will be listed and described.

(1) A synthetic single crystal diamond according to the present disclosure is a synthetic single crystal diamond in which a content ratio of nitrogen based on the number of atoms is 1 ppm or less and a content ratio of boron based on the number of atoms is 0.01 ppm or more and 3 ppm or less, wherein

the content ratio of the boron based on the number of atoms is more than the content ratio of the nitrogen based on the number of atoms, and

no absorption peak exists in a wavenumber range of 2790 cm$^{-1}$ or more and 2810 cm$^{-1}$ or less in an infrared absorption spectrum of the synthetic single crystal diamond measured by Fourier transform infrared spectroscopy.

According to the present disclosure, it is possible to provide a synthetic single crystal diamond that can be used as an infrared optical component.

(2) In (1), a Knoop hardness of the synthetic single crystal diamond in a <100> direction in a {001} plane is 80 GPa or more. The Knoop hardness is measured in accordance with JIS Z 2251:2009 under a condition of a temperature of 23°C ±5°C and a test load of 4.9 N.

According to this, the synthetic single crystal diamond can be suitably used as a material for an infrared optical component, which requires particularly high hardness, such as a compression cell, an ATR prism, a sample plate, a high pressure-proof window, or an anvil for generating high pressure.

(3) In (1) or (2), a crack generation load of the synthetic single crystal diamond may be 10 N or more. The crack generation load is measured in a breaking strength test in which a diamond indenter having a spherical shape with a tip radius of 50 μm is pressed against a surface of the synthetic single crystal diamond at a loading rate of 100 N/min.

According to this, the synthetic single crystal diamond can be suitably used as a material for an infrared optical component, which requires particularly high strength, such as a compression cell, an ATR prism, a sample plate, a high pressure-proof window, or an anvil for generating high pressure.

(4) A method of producing a synthetic single crystal diamond according to the present disclosure is a method of producing the synthetic single crystal diamond according to any one of (1) to (3), the method comprising:

a first step of synthesizing a diamond single crystal by a temperature difference method using a solvent metal, the diamond single crystal being a diamond single crystal in which a content ratio of nitrogen based on the number of atoms is 1 ppm or less, a content ratio of boron based on the number of atoms is 0.01 ppm or more and 3 ppm or less, and the content ratio of the boron based on the number of atoms is more than the content ratio of the nitrogen based on the number of atoms; and

a second step of obtaining the synthetic single crystal diamond by applying, to the diamond single crystal, one or both of an electron beam and a particle beam that each provide an energy of 1 MGy or more and less than 10 MGy.

According to the present disclosure, it is possible to provide a synthetic single crystal diamond that can be used as an infrared optical component.

(5) In the second step in (4), the electron beam may be applied to the diamond single crystal under a condition of an energy of 1.0 MeV or more and 10 MeV or less and a dose amount of $1.0 \times 10^{19}$ e/m$^2$ or more and $1.0 \times 10^{21}$ e/m$^2$ or less so as to provide the diamond single crystal with the energy of 1 MGy or more and less than 10 MGy.

(6) An infrared optical component according to the present disclosure is an infrared optical component comprising the synthetic single crystal diamond according to any one of (1) to (3).

According to the present disclosure, it is possible to provide an infrared optical component in which background noise at the time of infrared optical spectrum measurement is not recognized.

[Details of Embodiments of the Present Disclosure]

Specific examples of the synthetic single crystal diamond, the method of producing the synthetic single crystal diamond, and the infrared optical component according to the present disclosure will be described below with reference to the figures. In the figures of the present disclosure, the same reference characters represent the same or corresponding portions. Further, a dimensional relation such as a length, a width, a thickness, or a depth is appropriately changed for clarity and simplification of the figures, and therefore do not necessarily represent an actual dimensional relation.

In the present specification, the expression "A to B" represents a range of lower to upper limits (i.e., A or more and B or less), and when no unit is indicated for A and a unit is indicated only for B, the unit of A is the same as the unit of B.

In the present disclosure, when one or more numerical values are described as each of lower and upper limits of a numerical range, it is assumed that a combination of any one numerical value described as the lower limit and any one numerical value described as the upper limit is also disclosed. For example, in the case where a1 or more, b1 or more, and c1 or more are each described as the lower limit and a2 or less, b2 or less, and c2 or less are each described as the upper limit, it is assumed that a1 or more and a2 or less, a1 or more and b2 or less, a1 or more and c2 or less, b1 or more and a2 or less, b1 or more and b2 or less, b1 or more and c2 or less, c1 or more and a2 or less, c1 or more and b2 or less, and c1 or more and c2 or less are disclosed.

In the present disclosure, a generic plane orientation including equivalent plane orientations in terms of crystal geometry is represented by { }, and a generic direction including equivalent directions in terms of crystal geometry is represented by <>.

[First Embodiment: Synthetic Single Crystal Diamond]

A synthetic single crystal diamond according to one embodiment of the present disclosure (hereinafter, also referred to as "first embodiment") is a synthetic single crystal diamond in which a content ratio of nitrogen based on the number of atoms (hereinafter, also referred to as "nitrogen content ratio") is 1 ppm or less and a content ratio of boron based on the number of atoms (hereinafter, also referred to as "boron content ratio") is 0.01 ppm or more and 3 ppm or less, wherein

the content ratio of the boron based on the number of atoms is more than the content ratio of the nitrogen based on the number of atoms, and

no absorption peak exists in a wavenumber range of 2790 cm$^{-1}$ or more and 2810 cm$^{-1}$ or less in an infrared absorption spectrum of the synthetic single crystal diamond measured by Fourier transform infrared spectroscopy.

<Content Ratio of Nitrogen Based on Number of Atoms>

The nitrogen content ratio of the synthetic single crystal diamond according to the first embodiment is 1 ppm or less and is less than the boron content ratio. The upper limit of the nitrogen content ratio of the synthetic single crystal diamond is less than the boron content and is 1 ppm or less, and may be 0.8 ppm or less, 0.05 ppm or less, 0.04 or less, 0.03 ppm or less, or 0.02 ppm or less, from the viewpoint of suppressing background noise at the time of infrared optical spectrum measurement. The lower limit of the nitrogen content ratio of the synthetic single crystal diamond is not particularly limited, and may be 0 ppm or more, or 0.008 ppm or more. The nitrogen content ratio of the synthetic single crystal diamond may be 0 ppm or more and 1 ppm or less, 0.008 ppm or more and 1 ppm or less, 0 ppm or more and 0.8 ppm or less, or 0.008 ppm or more and 0.8 ppm or less.

The nitrogen content ratio of the synthetic single crystal diamond is measured by using secondary ion mass spectrometry (SIMS: Secondary Ion Mass Spectrometry) using "IMS-7f" (trademark) provided by CAMECA as a measurement device and by using Cs$^+$ ion of 15.0 keV as a primary ion beam.

<Content Ratio of Boron Based on Number of Atoms>

The boron content ratio of the synthetic single crystal diamond according to the first embodiment is 0.01 ppm or more and 3 ppm or less, and is more than the nitrogen content ratio. The upper limit of the boron content ratio of the synthetic single crystal diamond is 3 ppm or less, may be 2.3 ppm or less, may be 1.5 ppm or less, may be 0.21 ppm or less, may be 0.19 ppm or less, or may be 0.11 ppm or less, from the viewpoint of suppressing background noise at the time of infrared optical spectrum measurement. The lower limit of the boron content ratio of the synthetic single crystal diamond is 0.01 ppm or more, and may be 0.05 ppm or more. The boron content ratio of the synthetic single crystal diamond is 0.01 ppm or more and 3 ppm or less, may be 0.01 ppm or more and 2.3 ppm or less, and may be 0.05 ppm or more and 2.3 ppm or less.

The boron content ratio of the synthetic single crystal diamond is measured by the secondary ion mass spectrometry (SIMS: Secondary Ion Mass Spectrometry). A specific measurement method is the same as the above-described method of measuring the nitrogen content ratio of the synthetic single crystal diamond.

<Other Impurity>

The synthetic single crystal diamond according to the first embodiment may include an impurity other than the nitrogen and the boron. Examples of the impurity include hydrogen. The total content ratio of the impurity other than the nitrogen and the boron based on the number of atoms in the synthetic single crystal diamond according to the first embodiment can be 10 ppm or less.

<Infrared Absorption Spectrum>

In the infrared absorption spectrum of the synthetic single crystal diamond according to the first embodiment measured by Fourier transform infrared spectroscopy, no absorption peak exists in the wavenumber range of 2790 $cm^{-1}$ or more and 2810 $cm^{-1}$ or less. The absorption peak having the wavenumber range of 2790 $cm^{-1}$ or more and 2810 $cm^{-1}$ or less is originated from isolated substitutional boron atom having positive (+) charge. The absorption peak in the wavenumber range of 2790 $cm^{-1}$ or more and 2810 $cm^{-1}$ or less as caused by the positive (+) charge becomes background noise when the infrared optical spectrum is measured using an infrared optical component in which the synthetic single crystal diamond is used as its material. Since no absorption peak exists in the wavenumber range of 2790 $cm^{-1}$ or more and 2810 $cm^{-1}$ or less in the infrared absorption spectrum of the synthetic single crystal diamond according to the first embodiment, the background noise at the time of infrared optical spectrum measurement can be eliminated.

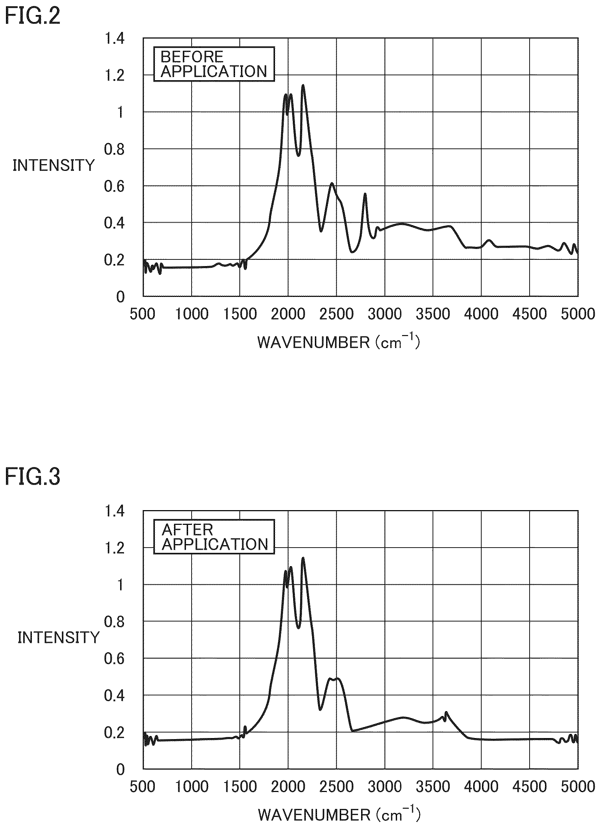

In the present disclosure, the expression "no absorption peak exists in the wavenumber range of 2790 $cm^{-1}$ or more and 2810 $cm^{-1}$ or less in the infrared absorption spectrum" means that absorption other than the absorption spectrum intrinsic to diamond is not recognized in the spectrum in the wavenumber range. This means that no local maximum value exists macroscopically in the wavenumber range of 2790 $cm^{-1}$ or more and 2810 $cm^{-1}$ or less in the infrared absorption spectrum. The absorption spectrum intrinsic to diamond in the wavenumber range of 2790 $cm^{-1}$ or more and 2810 $cm^{-1}$ or less corresponds to, for example, the infrared absorption spectrum shown in Fig. 3. In the infrared absorption spectrum of Fig. 3, the horizontal axis represents wavenumber ($cm^{-1}$) and the vertical axis represents intensity. In the infrared absorption spectrum of Fig. 3, no local maximum value exists macroscopically in the wavenumber range of 2790 $cm^{-1}$ or more and 2810 $cm^{-1}$ or less, and absorption other than that in the absorption spectrum intrinsic to diamond is not recognized. Therefore, in the infrared absorption spectrum of Fig. 3, it is determined that no absorption peak exists in the wavenumber range of 2790 $cm^{-1}$ or more and 2810 $cm^{-1}$ or less.

In the present disclosure, the infrared absorption spectrum of the synthetic single crystal diamond is obtained by performing measurement by Fourier transform infrared spectroscopy at a temperature of 23°C±2°C (21°C or more and 25°C or less). A measurement procedure is as follows. The synthetic single crystal diamond serving as a measurement sample is processed into a plate shape having a thickness of about 1 mm, and two surfaces through which light is allowed to pass are polished by a metal-bonded grindstone so as to attain a surface roughness Ra of 20 nm or less. Infrared ray is applied to each of the polished surfaces so as to create an infrared absorption spectrum. A change in temperature of each of the measurement device and the sample at the time of the measurement is suppressed to ±1°C or less.

Each of experiments No. 1 to No. 3 in Table 2 of the Example of PTL 1 show that there is no absorption at a wavenumber of 2807 $cm^{-1}$ in the infrared absorption spectrum in the synthetic diamond in which the boron content in the crystal is 3 ppm or less. In each of experiments No. 1 and No. 2, the boron content is the same as the nitrogen content, whereas in experiment No. 3, the boron content is less than the nitrogen content. As a result of further review by the present inventors, even when the boron content is 3 ppm or less, if the boron content is slightly more than the nitrogen content, absorption at the wavenumber of 2807 $cm^{-1}$ was confirmed in the infrared absorption spectrum. As a result of diligent study, the present inventors have found a method of obtaining the synthetic single crystal diamond in which no absorption peak exists in the wavenumber range of 2790 $cm^{-1}$ or more and 2810 $cm^{-1}$ or less in the infrared absorption spectrum even when the boron content is more than the nitrogen content, thereby completing the synthetic single crystal diamond according to the present disclosure.

<Knoop Hardness in <100> Direction in {001} Plane>

A Knoop hardness (also referred to as "{001}<100> Knoop hardness" in the present disclosure) in a <100> direction in a {001} plane of the synthetic single crystal diamond according to the first embodiment is 80 GPa or more. According to this, the synthetic single crystal diamond can be suitably used as a material for a component, which requires particularly high hardness, such as a compression cell, an ATR prism, a sample plate, a high pressure-proof window, or an anvil for generating high pressure.

The lower limit of the {001}<100> Knoop hardness of the synthetic single crystal diamond may be 80 GPa or more, 83 GPa or more, 87 GPa or more, or 90 GPa or more. The upper limit of the {001}<100> Knoop hardness is not particularly limited, but may be, for example, 100 GPa or less, 96 GPa or less, or 94 GPa or less. The {001}<100> Knoop hardness may be 80 GPa or more and 100 GPa or less, 80 GPa or more and 96 GPa or less, or 83 GPa or more and 96 GPa or less.

The {001}<100> Knoop hardness (unit: GPa) of the synthetic single crystal diamond is measured in accordance with JIS Z 2251:2009 under a condition of a temperature of 23°C±5°C (18°C or more and 28°C or less) and a test load of 4.9 N. The measurement procedure is as follows. First, an indentation is formed in the <100> direction in the {001} plane of the synthetic single crystal diamond at a load of 4.9 N. A longer diagonal line a (μm) of the obtained indentation is measured, and the {001}<100> Knoop hardness is calculated in accordance with the following formula.

$${001}<100> \text{ Knoop hardness (unit: GPa)} = 14229 \times 4.9/a^2$$

<Crack Generation Load>

A crack generation load of the synthetic single crystal diamond according to the first embodiment is preferably 10 N or more. According to this, the synthetic single crystal diamond has excellent breakage strength and breakage resistance. Therefore, the synthetic single crystal diamond can be suitably used as a material for an infrared optical component, which requires particularly high strength, such as a compression cell, an ATR prism, a sample plate, a high pressure-proof window, or an anvil for generating high pressure.

The lower limit of the crack generation load of the synthetic single crystal diamond may be 10 N or more, 12 N or more, 15 N or more, or 16 N or more. The upper limit value of the crack generation load is not particularly limited, but may be 50 N or less, or 16 N or less from the viewpoint of production. The crack generation load of the synthetic single crystal diamond may be 10 N or more and 50 N or less, 12 N or more and 50 N or less, or 15 N or more and 50 N or less.

The crack generation load of the synthetic single crystal diamond is measured by the following procedure. A spherical diamond indenter having a tip radius (R) of 50 μm is pressed against the (100) plane of the synthetic single crystal diamond. In this state, a load is applied to the single crystal diamond at a loading rate of 100 N/min, and a load (crack generation load) at a moment at which a crack is generated in the synthetic single crystal diamond is measured. The moment of generation of crack is measured by an AE sensor. A measurement temperature is 25°C.

[Second Embodiment: Method of Producing Synthetic Single Crystal Diamond]

A method of producing a synthetic single crystal diamond according to one embodiment (hereinafter, also referred to as "second embodiment") of the present disclosure is a method of producing the synthetic single crystal diamond according to the first embodiment, the method including:

a first step of synthesizing a diamond single crystal by a temperature difference method using a solvent metal, the diamond single crystal being a diamond single crystal in which a content ratio of nitrogen based on the number of atoms is 1 ppm or less, a content ratio of boron based on the number of atoms is 0.01 ppm or more and 3 ppm or less, and the content ratio of the boron based on the number of atoms is more than the content ratio of the nitrogen based on the number of atoms; and

a second step of obtaining the synthetic single crystal diamond by applying, to the diamond single crystal, one or both of an electron beam and a particle beam that each provide an energy of 1 MGy or more and less than 10 MGy.

<First Step>

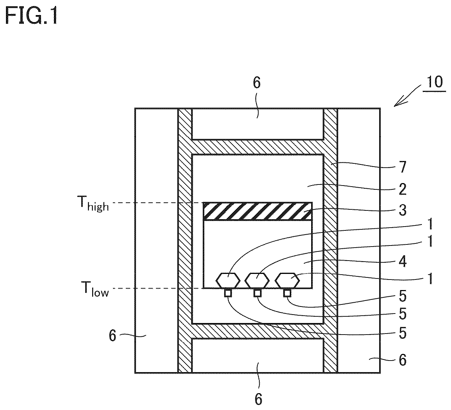

In the first step, the diamond single crystal is synthesized by a temperature difference method using a solvent metal, the diamond single crystal being a diamond single crystal in which the content ratio of the nitrogen based on the number of atoms is 1 ppm or less, the content ratio of the boron based on the number of atoms is 0.01 ppm or more and 3 ppm or less, and the content ratio of the boron based on the number of atoms is more than the content ratio of the nitrogen based on the number of atoms. For example, the diamond single crystal can be produced by the temperature difference method using a sample chamber having a configuration shown in Fig. 1.

As shown in Fig. 1, in a sample chamber 10 used to produce a diamond single crystal 1, an insulator 2, a carbon source 3, a solvent metal 4, and a seed crystal 5 are disposed in a space surrounded by a graphite heater 7, and a pressure medium 6 is disposed outside graphite heater 7. The temperature difference method is a synthesis method in which a vertical temperature gradient is provided in sample chamber 10, carbon source 3 is disposed at a high-temperature portion

($T_{high}$), diamond seed crystal 5 is disposed at a low-temperature portion ($T_{low}$), solvent metal 4 is disposed between carbon source 3 and seed crystal 5, and diamond single crystal 1 is grown on seed crystal 5 while maintaining a temperature to be equal to or more than a temperature at which solvent metal 4 is melted and maintaining a pressure to be equal to or more than a pressure at which the diamond is thermally stable. For example, the pressure in the sample chamber is controlled to fall within a range of 5.0 to 6.0 GPa and the temperature in the low temperature portion is controlled to fall within a range of 1360°C to 1380°C and are maintained for 50 to 200 hours so as to grow the diamond single crystal on the seed crystal.

As carbon source 3, diamond powder is preferably used. Moreover, graphite (graphite) or pyrolytic carbon can also be used. Carbon source 3 may include boron (B) as an impurity. The carbon source (diamond powder), which is affordable in cost and readily available, includes more than several ten ppm of boron as an impurity. Since the diamond single crystal synthesized using such a carbon source includes 3 ppm or less of boron as an impurity, absorption appears at a wavenumber of 2800 cm$^{-1}$ in an infrared absorption spectrum of the diamond single crystal, thus resulting in background noise. Therefore, the diamond single crystal cannot be used as an infrared optical component without modification. According to the production method according to the second embodiment, a synthetic single crystal diamond including boron as an impurity can also be applied to an infrared optical component by performing the below-described second step onto the diamond single crystal.

As solvent metal 4, one or more metals selected from iron (Fe), cobalt (Co), nickel (Ni), manganese (Mn), and the like, or an alloy including these metals can be used. Solvent metal 4 may further include one or more elements selected from a group consisting of titanium (Ti), vanadium (V), chromium (Cr), copper (Cu), zirconium (Zr), niobium (Nb), molybdenum (Mo), ruthenium (Ru), rhodium (Rh), hafnium (Hf), tantalum (Ta), tungsten (W), osmium (Os), iridium (Ir), and platinum (Pt). Solvent metal 4 may include boron (B) as an impurity.

<Second Step>

In the second step, one or both of the electron beam and the particle beam that each provide an energy of 1 MGy or more and less than 10 MGy is applied to the diamond single crystal obtained in the first step, so as to obtain the synthetic single crystal diamond.

The present inventors newly found that no absorption peak exists in the wavenumber range of 2790 cm$^{-1}$ or more and 2810 cm$^{-1}$ or less in the infrared absorption spectrum of the obtained synthetic single crystal diamond measured by Fourier transform infrared spectroscopy by applying, to the diamond single crystal obtained in the first step, one or both of the electron beam and the particle beam that each provide the energy of 1 MGy or more and less than 10 MGy (hereinafter, also referred to as "application of electron beam and/or the like"). That is, it has been newly found that the absorption peak in the wavenumber range of 2790 cm$^{-1}$ or more and 2810 cm$^{-1}$ or less, which is originated from isolated substitutional boron atom having positive (+) charge as observed in the infrared absorption spectrum of a conductive IIa type crystal (or IIb type crystal) including boron, ceases to exist due to the application of electron beam and/or the like that provides the energy of 1 MGy or more and less than 10 MGy.

Reasons for the above are unknown, but are presumed as follows. By applying, to the diamond single crystal, the electron beam and/or the like that provides the energy of 1 MGy or more and less than 10 MGy, a composite of vacancies (V) is formed in the crystal lattice of the synthetic single crystal diamond, thereby generating negative (-) charge in the synthetic single crystal diamond. The negative (-) charge compensates for the positive (+) charge of the isolated substitutional boron atom. Thus, it is presumed that the absorption peak ceases to exist in the wavenumber range of 2790 cm$^{-1}$ or more and 2810 cm$^{-1}$ or less in the infrared absorption spectrum.

In the infrared absorption spectrum of the obtained synthetic single crystal diamond measured by Fourier transform infrared spectroscopy, no absorption peak exists in the wavenumber range of 2790 cm$^{-1}$ or more and 2810 cm$^{-1}$ or less, and the infrared region is only absorption by phonon of diamond. Therefore, an infrared optical component using the obtained synthetic single crystal diamond as its material can reduce background noise at the time of infrared optical spectrum measurement.

When an amount of energy to be applied is less than 1 MGy, formation of the composite of vacancies (V) may be insufficient. On the other hand, when the amount of energy is 10 MGy or more, an excessive amount of vacancies may be generated, with the result that crystallinity may be decreased. Therefore, the amount of energy is suitably 1 MGy or more and less than 10 MGy.

As the particle beam, a neutron beam or a proton beam can be used. A condition for application thereof is not particularly limited as long as the energy of 1 MGy or more and less than 10 MGy can be provided to the diamond single crystal. The condition for application thereof may be such a condition that an energy of 1 MGy or more and 5 MGy or less can be provided to the diamond single crystal.

In the second step, the diamond single crystal obtained in the first step may be processed to have a thickness of 0.1 mm or more and 10 mm or less in the case of a size of 10 mm square, for example. In this case, a condition for application of electron beam can be, for example, an electron beam energy of 1.0 MeV or more and 10 MeV or less and a dose amount of $1.0 \times 10^{19}$ e/m$^2$ or more and $1.0 \times 10^{21}$ e/m$^2$ or less. A range in which the electron beam is applied is larger than a surface (region) in which the electron beam is applied in the diamond single crystal.

[Third Embodiment: Infrared Optical Component]

An infrared optical component according to one embodiment (hereinafter, also referred to as "third embodiment") of the present disclosure is an infrared optical component including the synthetic single crystal diamond according to the first embodiment. Examples of the infrared optical component include components such as a compression cell, an ATR prism, a sample plate, a high pressure-proof window, and an anvil for generating high pressure.

Examples

The present embodiment will be described more specifically with reference to examples. However, the present embodiment is not limited by these examples.

<Production of Synthetic Single Crystal Diamond>

<<First Step>>

A sample chamber having the configuration shown in Fig. 1 is used to synthesize a diamond single crystal of each sample by the temperature difference method using a solvent metal.
An iron-cobalt alloy (Fe-Co alloy) was used as the solvent metal, and titanium (Ti) was added to the solvent metal as a nitrogen getter. An amount of addition of the titanium to the solvent metal in each sample is as shown in the column "Ti Addition Amount" of the "Solvent Metal" in the "First Step" in Table 1. For example, "2.0 mass%" of sample 1 means that a ratio of the mass of the solvent metal to the amount (mass) of addition of the titanium is the solvent metal : the titanium = 100:2. By changing the amount of addition of the titanium to the solvent metal, the nitrogen content ratio in the diamond single crystal to be synthesized can be adjusted.
For a carbon source, various types of diamond powders having different boron content ratios were used. The boron content ratio of the diamond powder used in each sample is as shown in the column "B Content Ratio" of the "Carbon Source" in the "First Step" in Table 1. A diamond single crystal having a diameter of about 0.5 mm was used as a seed crystal. By adjusting the boron content ratio of the diamond powder, the boron content ratio in the diamond single crystal to be synthesized can be adjusted.
A temperature in the sample chamber was adjusted by a heater so as to make a temperature difference of several ten degrees between a high-temperature portion in which the carbon source was disposed and a low-temperature portion in which the seed crystal was disposed. Then, an ultra-high pressure generation apparatus is used to control the pressure to be 5.5 GPa and control the temperature of the low temperature portion to fall within a range of 1370°C±10°C (1360°C to 1380°C) and maintain them for 60 hours, thereby synthesizing the diamond single crystal on the seed crystal.
The nitrogen content ratio and the boron content ratio of the diamond single crystal of each sample were measured by SIMS. A specific measurement method is as described in the first embodiment. Results are shown in the columns "N Content Ratio" and "B Content Ratio" of "Diamond Single Crystal" in Table 1.

<<Second Step>>

Next, an electron beam that provides an energy of 5 MGy or 1 MGy is applied to the obtained diamond single crystal, thereby obtaining the synthetic single crystal diamond of each sample. In the case of providing the energy of 5 MGy, a condition for application of electron beam was an electron beam energy of 2 MeV and a dose amount of $2\times10^{20}$ e/m$^2$. In the case of providing the energy of 1 MGy, the energy of the electron beam was 2 MeV and the dose amount was $4\times10^{19}$ e/m$^2$. Regarding the size of the diamond single crystal, the diameter of a circle inscribed to a main surface thereof was about 5 mm. In Table 1, the application of electron beam was not performed onto samples each denoted as "Not Applied" in the column "Application of Electron Beam" of the "Second Step".

[Table 1]

Table 1

| Sample No. | Production Method | | | | | |
| --- | --- | --- | --- | --- | --- | --- |
| | First Step | | | | Second Step | |
| | Solvent Metal | Carbon Source | Diamond Single Crystal | | Application of Electron Beam | |
| | Ti Addition Amount | B Content Ratio | N Content Ratio | B Content Ratio | Applied/ Not Applied | Energy |
| | mass% | ppm | ppm | ppm | | MGy |
| 1 | 2.0 | 5 | 0.008 | 0.05 | Not Applied | - |
| 2 | 2.0 | 5 | 0.008 | 0.05 | Applied | 5 |
| 3 | 1.5 | 10 | 0.020 | 0.11 | Not Applied | - |
| 4 | 1.5 | 10 | 0.020 | 0.11 | Applied | 5 |
| 5 | 1.3 | 20 | 0.040 | 0.19 | Not Applied | - |
| 6 | 1.3 | 20 | 0.040 | 0.19 | Applied | 5 |
| 7 | 1.2 | 20 | 0.050 | 0.21 | Not Applied | - |
| 8 | 1.2 | 20 | 0.050 | 0.21 | Applied | 5 |
| 9 | 1.4 | 150 | 0.030 | 1.50 | Not Applied | - |
| 10 | 1.4 | 150 | 0.030 | 1.50 | Applied | 5 |
| 11 | 0.9 | 250 | 0.800 | 2.30 | Not Applied | - |
| 12 | 0.9 | 250 | 0.800 | 2.30 | Applied | 5 |
| 13 | 0.7 | 300 | 1.000 | 3.00 | Not Applied | - |
| 14 | 0.7 | 300 | 1.000 | 3.00 | Applied | 5 |
| 15 | 2.0 | 1 | 0.008 | 0.01 | Not Applied | - |
| 16 | 2.0 | 1 | 0.008 | 0.01 | Applied | 5 |
| 17 | 0.7 | 350 | 1.000 | 3.50 | Not Applied | - |
| 18 | 0.7 | 350 | 1.000 | 3.50 | Applied | 5 |
| 19 | 2.0 | 300 | 0.008 | 3.00 | Applied | 5 |
| 20 | 2.0 | 300 | 0.008 | 3.00 | Applied | 1 |

<Evaluation>

For the synthetic single crystal diamond of each sample, the nitrogen content ratio and the boron content ratio were measured, analysis by infrared spectroscopy was performed, and the {100}<100> Knoop hardness and the crack generation load were measured.

<<Measurement of Nitrogen Content Ratio and Boron Content Ratio>>

The nitrogen content ratio and the boron content ratio of the synthetic single crystal diamond of each sample were measured by SIMS. Specific measurement condition is as described in the first embodiment. In all the samples, it was confirmed that the nitrogen content ratio and the boron content ratio of the synthetic single crystal diamond were the same as the nitrogen content ratio and the boron content ratio of the diamond single crystal described in Table 1. In each sample, the value obtained by subtracting the nitrogen content ratio from the boron content ratio is shown in the column "B-A" in Table 2.

<<Analysis by Infrared Spectroscopy>>

The synthetic single crystal diamond of each sample was processed into a plate having a thickness of about 1 mm, and its two surfaces, through each of which light was allowed to pass, were polished with a metal-bonded grindstone so as to attain a surface roughness Ra of 20 nm or less, and then an infrared absorption spectrum was prepared using an infrared spectrophotometer.

In the infrared absorption spectrum of each sample, it was confirmed whether or not an absorption peak exists in the wavenumber range of 2790 $cm^{-1}$ or more and 2810 $cm^{-1}$ or less. Results are shown in the column "Wavenumber 2790-2810 $cm^{-1}$ Absorption Peak" of the "Infrared Absorption Spectrum" of the "Synthetic Single Crystal Diamond" in Table 2. In this column, "Exist" indicates that an absorption peak exists within the above range. In this column, "Not Exist" indicates that there is no absorption peak within the above range.

Fig. 2 shows an infrared absorption spectrum of the diamond single crystal produced in sample 7 before application of electron beam, and Fig. 3 shows an infrared absorption spectrum of the synthetic single crystal diamond produced in sample 7 after application of electron beam. In each of the infrared absorption spectra of Figs. 2 and 3, the horizontal axis represents wavenumber ($cm^{-1}$), and the vertical axis represents intensity. It is confirmed that in the infrared absorption spectrum of the diamond single crystal before the application of electron beam (Fig. 2), an absorption peak exists in the wavenumber range of 2790 $cm^{-1}$ or more and 2810 $cm^{-1}$ or less, but in the infrared absorption spectrum of the synthetic single crystal diamond after the application of electron beam (Fig. 3), no absorption peak exists in the wavenumber range of 2790 $cm^{-1}$ or more and 2810 $cm^{-1}$ or less.

In the infrared absorption spectrum of each sample, an absorption intensity IA of an absorption signal in the wavenumber range of 2790 $cm^{-1}$ or more and 2810 $cm^{-1}$ or less and an absorption intensity IB at a wavenumber of 2157 $cm^{-1}$ were measured, and the percentage (%) of IA with respect to IB was calculated. Results are shown in the column "IA/IB (%)" in Table 2. When "IA/IB (%)" is "0", it is indicated that no absorption by isolated substitutional boron having positive charge is present on the spectrum intrinsic to diamond.

<<Measurement of {001}<100> Knoop Hardness>>

The {001}<100> Knoop hardness of the synthetic single crystal diamond of each sample was measured. A specific measurement method is as described in the first embodiment. Results are shown in the column "{001}<100> Knoop Hardness" of "Synthetic Single Crystal Diamond" in Table 2.

<<Measurement of Crack Generation Load>>

A crack generation load of the synthetic single crystal diamond of each sample was measured. A specific measurement method is as described in the first embodiment. Results are shown in the column "Crack Generation Load" of "Synthetic Single Crystal Diamond" in Table 2.

[Table 2]

Table 2

| Sample No. | Synthetic Single Crystal Diamond | | | | | | |
| | N Content Ratio | B Content Ratio | B-A | Infrared Absorption Spectrum | | {001}<100> Knoop Hardness | Crack Generation Load |
| | | | | Wavenumber 2790-2810 $cm^{-1}$ Absorption Peak | IA/IB | | |
| | ppm | ppm | ppm | Exist/ Not Exist | % | GPa | N |
| 1 | 0.008 | 0.05 | 0.04 | Exist | 0.11 | 121 | 9 |
| 2 | 0.008 | 0.05 | 0.04 | Not Exist | 0 | 96 | 10 |
| 3 | 0.020 | 0.11 | 0.09 | Exist | 0.22 | 123 | 9 |
| 4 | 0.020 | 0.11 | 0.09 | Not Exist | 0.00 | 94 | 12 |
| 5 | 0.040 | 0.19 | 0.15 | Exist | 0.39 | 123 | 8 |
| 6 | 0.040 | 0.19 | 0.15 | Not Exist | 0 | 90 | 15 |
| 7 | 0.050 | 0.21 | 0.16 | Exist | 0.43 | 125 | 8 |
| 8 | 0.050 | 0.21 | 0.16 | Not Exist | 0 | 87 | 15 |

(continued)

| Sample No. | Synthetic Single Crystal Diamond | | | | | | |
|---|---|---|---|---|---|---|---|
| | N Content Ratio | B Content Ratio | B-A | Infrared Absorption Spectrum | | {001}<100> Knoop Hardness | Crack Generation Load |
| | | | | Wavenumber 2790-2810 cm$^{-1}$ Absorption Peak | IA/IB | | |
| | ppm | ppm | ppm | Exist/ Not Exist | % | GPa | N |
| 9 | 0.030 | 1.50 | 1.47 | Exist | 1.30 | 127 | 8 |
| 10 | 0.030 | 1.50 | 1.47 | Not Exist | 0 | 83 | 16 |
| 11 | 0.800 | 2.30 | 1.50 | Exist | 1.80 | 128 | 8 |
| 12 | 0.800 | 2.30 | 1.50 | Not Exist | 0 | 81 | 16 |
| 13 | 1.000 | 3.00 | 2.00 | Exist | 2.10 | 128 | 10 |
| 14 | 1.000 | 3.00 | 2.00 | Not Exist | 0 | 80 | 17 |
| 15 | 0.008 | 0.01 | 0.002 | Exist | 0.02 | 123 | 10 |
| 16 | 0.008 | 0.01 | 0.002 | Not Exist | 0 | 98 | 11 |
| 17 | 1.000 | 3.50 | 2.50 | Exist | 2.30 | 128 | 15 |
| 18 | 1.000 | 3.50 | 2.50 | Exist | 0.20 | 75 | 9 |
| 19 | 0.008 | 3.00 | 2.99 | Not Exist | 0 | 80 | 12 |
| 20 | 0.008 | 3.00 | 2.99 | Not Exist | 0 | 83 | 10 |

<Review>

Samples 2, 4, 6, 8, 10, 12, 14, 16, 19, and 20 correspond to examples of the present disclosure. In each of these synthetic single crystal diamonds, the boron content ratio is more than the nitrogen content ratio, but no absorption peak exists in the wavenumber range of 2790 cm$^{-1}$ or more and 2810 cm$^{-1}$ or less in the infrared absorption spectrum. Therefore, each of these can be used as an infrared optical component.

Samples 1, 3, 5, 7, 9, 11, 13, 15, 17, and 18 correspond to comparative examples. In the infrared absorption spectrum of each of these synthetic single crystal diamonds, an absorption peak exists in the wavenumber range of 2790 cm$^{-1}$ or more and 2810 cm$^{-1}$ or less. Therefore, each of these cannot be used as an infrared optical component.

Although the embodiments and examples of the present disclosure have been described as described above, it is also initially expected to appropriately combine or variously modify the configurations of the above-described embodiments and examples.

The embodiments and examples disclosed herein are illustrative and non-restrictive in any respect. The scope of the present invention is defined by the terms of the claims, rather than the embodiments and examples described above, and is intended to include any modifications within the scope and meaning equivalent to the terms of the claims.

REFERENCE SIGNS LIST

1 diamond single crystal; 2 insulator; 3 carbon source; 4 solvent metal; 5 seed crystal; 6 pressure medium; 7 graphite heater; 10 sample chamber.

**Claims**

1. A synthetic single crystal diamond in which a content ratio of nitrogen based on the number of atoms is 1 ppm or less and a content ratio of boron based on the number of atoms is 0.01 ppm or more and 3 ppm or less, wherein

the content ratio of the boron based on the number of atoms is more than the content ratio of the nitrogen based on the number of atoms, and
no absorption peak exists in a wavenumber range of 2790 cm$^{-1}$ or more and 2810 cm$^{-1}$ or less in an infrared absorption spectrum of the synthetic single crystal diamond measured by Fourier transform infrared spectroscopy.

2. The synthetic single crystal diamond according to claim 1, wherein

a Knoop hardness of the synthetic single crystal diamond in a <100> direction in a {001} plane is 80 GPa or more, and
the Knoop hardness is measured in accordance with JIS Z 2251:2009 under a condition of a temperature of 23°C $\pm$5°C and a test load of 4.9 N.

3. The synthetic single crystal diamond according to claim 1 or 2, wherein

a crack generation load of the synthetic single crystal diamond is 10 N or more, and
the crack generation load is measured in a breaking strength test in which a diamond indenter having a spherical shape with a tip radius of 50 $\mu$m is pressed against a surface of the synthetic single crystal diamond at a loading rate of 100 N/min.

4. A method of producing the synthetic single crystal diamond according to any one of claims 1 to 3, the method comprising:

a first step of synthesizing a diamond single crystal by a temperature difference method using a solvent metal, the diamond single crystal being a diamond single crystal in which a content ratio of nitrogen based on the number of atoms is 1 ppm or less, a content ratio of boron based on the number of atoms is 0.01 ppm or more and 3 ppm or less, and the content ratio of the boron based on the number of atoms is more than the content ratio of the nitrogen based on the number of atoms; and
a second step of obtaining the synthetic single crystal diamond by applying, to the diamond single crystal, one or both of an electron beam and a particle beam that each provide an energy of 1 MGy or more and less than 10 MGy.

5. The method of producing the synthetic single crystal diamond according to claim 4, wherein in the second step, the electron beam is applied to the diamond single crystal under a condition of an energy of 1.0 MeV or more and 10 MeV or less and a dose amount of $1.0 \times 10^{19}$ e/m$^2$ or more and $1.0 \times 10^{21}$ e/m$^2$ or less so as to provide the diamond single crystal with the energy of 1 MGy or more and less than 10 MGy.

6. An infrared optical component comprising the synthetic single crystal diamond according to any one of claims 1 to 3.

FIG.1

FIG.2

FIG.3

## INTERNATIONAL SEARCH REPORT

| International application No. |
| --- |
| **PCT/JP2024/013623** |

| | |
| --- | --- |
| **A. CLASSIFICATION OF SUBJECT MATTER** | |

***C30B 29/04***(2006.01)i; ***C01B 32/28***(2017.01)i; ***C30B 19/02***(2006.01)i; ***C30B 33/04***(2006.01)i; ***G02B 1/02***(2006.01)i;
***G02B 5/22***(2006.01)i
FI: C30B29/04 U; C30B33/04; C30B19/02; C01B32/28; G02B1/02; G02B5/22

According to International Patent Classification (IPC) or to both national classification and IPC

**B. FIELDS SEARCHED**

Minimum documentation searched (classification system followed by classification symbols)

C30B29/04; C01B32/28; C30B19/02; C30B33/04; G02B1/02; G02B5/22

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2022/097641 A1 (SUMITOMO ELECTRIC INDUSTRIES, LTD.) 12 May 2022 (2022-05-12) paragraphs [0010]-[0011], [0069], [0075], [0082]-[0096], table 1 | 1-3 |
| A | | 4-6 |
| A | JP 6-214102 A (SUMITOMO ELECTRIC INDUSTRIES, LTD.) 05 August 1994 (1994-08-05) entire text, all drawings | 1-6 |
| A | JP 2012-121748 A (SUMITOMO ELECTRIC INDUSTRIES, LTD.) 28 June 2012 (2012-06-28) entire text, all drawings | 1-6 |

☐ Further documents are listed in the continuation of Box C.    ☑ See patent family annex.

| | |
| --- | --- |
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **19 June 2024** | **02 July 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

**INTERNATIONAL SEARCH REPORT**
Information on patent family members

International application No.

**PCT/JP2024/013623**

| Patent document cited in search report | | | Publication date (day/month/year) | Patent family member(s) | | | Publication date (day/month/year) |
|---|---|---|---|---|---|---|---|
| WO | 2022/097641 | A1 | 12 May 2022 | US 2023/0383436 A1 paragraphs [0010]-[0011], [0080], [0087], [0095]-[0105], table 1 | | | |
| JP | 6-214102 | A | 05 August 1994 | US | 5569921 | A | |
| | | | | EP | 624785 | A1 | |
| | | | | ZA | 9306715 | A | |
| | | | | ZA | 936715 | B | |
| JP | 2012-121748 | A | 28 June 2012 | (Family: none) | | | |

Form PCT/ISA/210 (patent family annex) (July 2022)

**EP 4 692 427 A1**

**Patent documents cited in the description**

- JP 2023060358 A

- JP 6214102 A